(19) Europäisches Patentamt

European Patent Office

Office européen des brevets

(11) **EP 2 404 866 A1**

(12) **EUROPEAN PATENT APPLICATION**

(43) Date of publication:
**11.01.2012 Bulletin 2012/02**

(51) Int Cl.:
**B81B 1/00** (2006.01)   **B81C 1/00** (2006.01)
**B81B 3/00** (2006.01)

(21) Application number: **10169077.4**

(22) Date of filing: **09.07.2010**

(84) Designated Contracting States:
**AL AT BE BG CH CY CZ DE DK EE ES FI FR GB GR HR HU IE IS IT LI LT LU LV MC MK MT NL NO PL PT RO SE SI SK SM TR**
Designated Extension States:
**BA ME RS**

(71) Applicant: **Leibniz-Institut für Polymerforschung Dresden e.V.**
**01069 Dresden (DE)**

(72) Inventors:
• **Ionov, Leonid**
**01187 Dresden (DE)**

• **Puretskiy, Nikolay**
**01069 Dresden (DE)**
• **Stoychev, Georgi**
**01069 Dresden (DE)**
• **Stamm, Manfred**
**01705 Freital (DE)**

(74) Representative: **Westendorp | Sommer**
**Uhlandstrasse 2**
**80336 München (DE)**

(54) **Switchable surfaces based on freely floating colloidal particles**

(57)    The invention is directed to a switchable element comprising a substrate, a first material and colloidal particles, wherein the first material in a fluid state allows the colloidal particles to at least partially immerse into the first material, and wherein the colloidal particles are responsive to an external stimulus that changes their degree of immersion in the first material, and wherein at a temperature below the melting point of the first material the colloidal particles are fixed in their degree of immersion.

The invention is further directed to a method for the preparation of said switchable element; a method for preparing said switchable element having on a surface a pattern of at least one first area, wherein the colloidal particles have a first degree of immersion, and at least one second area, wherein the colloidal particles have a second degree of immersion different from said first degree of immersion; a method of physical switching said switchable element; and the use of said switchable element.

after annealing on air     after annealing in water

hydrophilic particles

wax

**Fig. 1**

**Description**

The invention relates to a switchable element comprising a substrate, a first material and colloidal particles; a method for the preparation of said switchable element; a method for preparing said switchable element having on a surface a pattern of at least one first area, wherein the colloidal particles have a first degree of immersion, and at least one second area, wherein the colloidal particles have a second degree of immersion different from said first degree of immersion; a method of physical switching said switchable element; and the use of said switchable element.

There is an increasing interest in chemistry surrounding the preparation, modification, physical characterization and manipulation of switchable surfaces on nanometer and micrometer scales, because said switchable surfaces can be potentially used in a wide spectrum of applications that range from optoelectronic devices to biological sensors.

Recently, surfaces with switchable/adaptive behavior have become an increasingly important material for design of microfluidic devices, sensors, functional coatings, logical devices and for biotechnological applications. These surfaces are very sensitive to any change in surrounding media, which can affect their optical parameters. Exploitation of this unusual phenomenon has given rise to new analytical and sensing techniques. To date, stimuli-responsive surfaces were designed mainly using self-assembled monolayers (SAM), polymer brushes or using metal oxides. Self-assembled monolayers have attracted considerable interest during the last decades and are formed spontaneously by immersing substrates in dilute solutions of amphiphilic molecules in appropriate solvents. A variety of film/substrate systems are known to lead to the formation of these highly ordered monolayer films.

Exposure to environmental stimulus or stimuli, such as solvent, pH, temperature and/or light (e.g. UV light), application of a magnetic field or an electrostatic charge, a change in capacitance and any combinations of the above, of these materials changes composition in the topmost surface layer that often affects wetting properties of a surface, which leads to changes in the e.g. optical and electrical properties of the topmost surface layer and therefore allows for various technical applications.

For example US 7,020,335 B2 reported the fabrication of a surface with reversible switchable properties comprising a nanolayer of a material, in particular a self-assembled monolayer. The nanolayer may include a plurality of molecular assemblies each having at least first and second information carriers. When an external stimulus is applied the nanolayer switches from a first confirmation state to a second confirmation state.

The switching range of wetting properties can be dramatically increased using rough substrates. According to equations of Wenzel (Wenzel, R. N. Ind. Eng. Chem. Res. 1936, 28, 988; Marmur, A. Langmuir 2003, 19, 8343; Marmur, A. Langmuir 2004, 20, 3517) and Cassie (Marmur, A. Langmuir 2003, 19, 8343; Cassie, A. B. D.; Baxter, S. Trans. Faraday Soc. 1944, 40, 546), roughness "enhances" intrinsic wetting properties of materials and makes hydrophilic/hydrophobic materials even more hydrophilic/hydrophobic.

Using this model, Minko et al. fabricated mixed hydrophobic-hydrophilic brushes grafted to rough substrates, which demonstrate very broad switching ranges between absolute wetting (water contact angle is close to 0°) and ultrahydrophobicity (water contact angle is more then 150°) (Minko, S.; Muller, M.; Motornov, M.; Nitschke, M.; Grundke, K.; Stamm, M. Journal of the American Chemical Society 2003, 125, 3896).

US 2007/0190299 A1 discloses the fabrication of a responsive coated substrate, said substrate comprising an interfacial surface to which a responsive coating attaches, said responsive coating comprising (a) at least one silicon-based, substantially hydrophobic polymer; and (b) at least one substantially hydrophilic polymer, wherein said responsive coating substrate is in a first state. The application of an external stimulus to said responsive coated substrate results in switching of said substrate from a first state to a second state.

US 2007/0190327 A1 relates to the fabrication of a responsive coated particle comprising at least one particle comprising an interfacial surface to which a responsive coating attaches, said responsive coating comprising (a) at least one silicone-based, substantially hydrophobic polymer; and (b) at least one substantially hydrophilic polymer, wherein said responsive coating particle is in a first state. The application of an external stimulus to said responsive coated particle results in switching of said particle from a first state to a second state.

Further, Sidorenko et al. (Sidorenko, A.; Krupenkin, T.; Taylor, A.; Fratzl, P.; Aizenberg, J. Science 2007, 315, 487) reported that surface roughness and resulting wetting properties of composite hydrogels can be switched by deformation.

Although the above-described switchable elements are suitable for some applications, there is still a need for new switchable elements having improved properties, and there is still further a need for improved method for preparing an advantageous switchable element.

It is therefore an object of the present invention to provide a new type of a switchable element comprising a substrate, a first material and colloidal particles as well as a method for preparing said switchable element, which may be obtained easily and which avoids the disadvantages of the prior art.

According to a first aspect of the invention, this object is achieved by the switchable element according to claim 1. Preferred embodiments of the switchable element of the present invention are described in the dependent claims.

It has surprisingly been found that the object of the invention can be achieved by the preparation of a specific switchable element where roughness depending on the degree of immersion of the colloidal particles in the first material can be switched by an external stimulus. As a result, switchable elements comprising a substrate, a first material and colloidal particles can be obtained having improved properties compared to switchable elements already known in the art or prepared by known methods.

It has further unexpectedly been found that the surface properties of the switchable element can be frozen by cooling said element below the melting temperature of the first materia l.

According to a first aspect, the present invention thus provides a switchable element comprising a substrate, a first material and colloidal particles, wherein the first material in a fluid state allows the colloidal particles to at least partially immerse into the first material, and wherein the colloidal particles are responsive to an external stimulus that changes their degree of immersion in the first material, and wherein at a temperature below the melting point of the first material the colloidal particles are fixed in their degree of immersion.

There are no particular restrictions to the substrate, it may play a neutral role and may e.g. act only as a basis for a first material, i.e. as a solid material or support. However, the substrate may also take an active position and may act e.g. as an electrode. The substrate may have a reflective surface or may be provided with a metal layer, e.g. gold layer. The substrate preferably should have a regular planar surface such that a regular and defined structure of the switchable element may be obtained. Suitable substrates are e.g. a glass /quartz plate or a silicon wafer. However, other materials may also be used. The substrate may be stiff or may be flexible and take e.g. the form of a thin foil. Such foil may be made, without limitation to those examples, from a metal, a metal oxide, or a plastic material, i.e. comprising an organic polymer. The substrate may be formed homogeneously of a particular material. However, it is also possible to use a substrate comprising several layers made of different materials. An example for such a substrate is e.g. a silicon wafer, on top of which is provided a layer of silicon dioxide.

According to an embodiment of the present invention, any substrate, including all classes of materials, such as metals, ceramics, glasses, non-crystalline materials, semiconductors, polymers and composites may be used in the present invention. Substrates may also be combined with each other, e.g. a substrate of one material may be coated or patterned with a second material.

The term "colloidal particles" refers to single microparticles and nanoparticles or aggregates of particles. As described herein, the colloidal particles are capable of at least partially immersion into the first material as described herein. According to one embodiment of the invention, the colloidal particles can have an additional functionality and can for example be used for a desired technical application, e.g. act as an electrode. The colloidal particles can e.g. comprise a reflective surface or a metal layer, a semiconductor layer or a magnetic layer coating, allowing usage of Surface Plasmon Resonance or UV-Vis spectroscopy or fluorescence spectroscopy as an analytical tool for detecting e.g. a stimulus. For some applications it can be suitable to use an isolating material for the colloidal particles, e.g. metal oxide or a material that has photo-luminescent properties or fluorescent properties. The material of the colloidal particles may be selected depending on the technical application for which the switchable element is used.

Colloidal particles suitable for the present invention preferably have a mean diameter within the range of 1 nm to 100 $\mu$m, more preferred within the range of 1 nm to 50 $\mu$m, particularly preferred within the range of 1 nm to 10 $\mu$m. The size of the colloidal particles is selected depending on the technical application for which the colloidal particles are used. For the use in optoelectronic applications the colloidal particles preferably have a mean diameter within the range of 1 nm to 1 $\mu$m. According to a further preferred embodiment, the colloidal particles have a mean diameter of less than 900 nm, more preferred less than 700 nm, particularly preferred less than 500 nm. According to a further preferred embodiment, the colloidal particles have a mean diameter of more than 10 nm, particularly preferred more than 15 nm. Preferably the colloidal particles have a mean diameter in the range of 20 nm to 500 nm, particularly preferred from 50 nm to 300 nm. The diameter is the largest dimension of a particle. The mean value is the arithmetic mean value.

In a further preferred embodiment, the colloidal particles have a narrow size distribution. Preferably, more than 80 % by number of the particles have a size within a range of $\pm$ 25 %, further preferred of $\pm$ 10 % of the mean diameter of the particles. The size of the particles may be determined e.g. by TEM (Transmission Electron Microscopy), DLS (Dynamic Light Scattering), SEM (Scanning Electron Microscopy) or AFM (Atomic Force Microscopy).

The colloidal particles preferably have a spherical shape but can also have another shape, e.g. the shape of a small platelet or a rod. Further preferred, the colloidal particles have a branched shape such as tetrapod. Alternatively, the colloidal particles can also have an irregular morphology. The colloidal particles can be massive or can be hollow. An example for hollow particles is e.g. a fullerene or a carbon nanotube. Massive colloidal particles having a spherical shape are preferred.

As already discussed, the colloidal particles according to the present invention may be made from any kind of material. According to a preferred embodiment, the colloidal particles consist of materials selected from silica or other oxides or hydroxides, e.g. $TiO_2$, $In_2O_3$, ZnO, $Fe_3O_4$, $Fe_2O_3$, magnesium hydroxide, aluminium hydroxide, metal, e.g. gold, silver, copper, platinum and alloys thereof, semiconductor e.g. CdSe, CdS, CdTe, $CuInS_2$, ZnS, ZnSe, ZnTe, PbS, PbSe, PbTe, Si, $HgI_2$, $In_2S_3$, $In_2Se_3In$, $In_2Te_3$, $Cd_3P_2$, $Cd_3As_2$, InAs, InP, GaP, GaAs, non-conductive materials or compositions or mixtures thereof.

According to a further preferred embodiment, the colloidal particles are inorganic or organic particles, wherein the inorganic particles are preferably selected from the group consisting of metals, metal oxides, metal hydroxides, semiconductor materials, non-conductive materials and silica, preferably FeO, $Fe_2O_3$ and $SiO_2$, or compositions or mixtures thereof; and wherein the organic particles are preferably polymer or (co)polymer particles, which are preferably selected from the group of thermoplastic materials comprising polystyrene, polyolefins, in particular polyethylene or polypropylene; polyacrylates, polymethacrylates; polyimides, polycarbonates, polyethersulfones, polyamides, polyesters; and polyvinyl chlorides; styrene-butadiene rubber (SBR); styrene-ethylene-butadiene-styrene copolymers (SEBS); butyl rubber; ethylene-propylene rubber (EPR); ethylene-propylene-diene-monomer rubber (EPDM); ethylene-vinyl acetate copolymer (EVA); ethylene-acrylate or butadiene-acrylonitrile; maleic anhydride modified polymers and copolymers; and graft copolymers; or compositions or mixtures thereof.

According to a further preferred embodiment of the invention, the colloidal particles may be unmodified or modified particles. The term "unmodified particles" refers to the particles, wherein no functionalization step comprising bearing chemically reactive moieties to the surface of the particles was used.

According to an another preferred embodiment of the invention, the colloidal particles are functionalized ("modified particles") with at least one reactive group in order to, for example, decrease aggregation of the colloidal particles. An exemplary compound that may be used in the present invention to modify particles is a silane derivative, preferably 3-aminopropyl-triethoxysilane or 3-glycidoxypropyl trimethoxysilane.

According to the present invention, the term "first material" refers to a substance which behaves as a solid under certain conditions and as a fluid under other conditions. According to one embodiment, it may behave as a fluid under an applied stress, e.g. temperature or pressure, or as a solid or semi-solid then this stress is not applied anymore.

According to a preferred embodiment of the invention, the first material is selected from polymers and waxes.

Waxes are water insoluble, organic materials that are solid or semi-solid at a temperature between 22 and 25°C (room temperature), usually of lower density than water, and typically can be melted above said temperature to form a fluid. Preferred waxes include any unmodified or modified naturally occurring and synthetic waxes, wax esters, and greases. Modified waxes according to the invention are (without limitation) e.g. selected from the group consisting of various plant derived waxes, greases and oils including carnauba wax, cranberry wax, ouricuri wax, candelilla wax, raphia wax, apple, cotton and cactus waxes; waxes (including greases) produced by bacteria (for example, cetyl-stearate); fungi, protozoa and algae; various invertebrate waxes and greases including insect waxes such as beeswaxes (for example, triacontylpalmitate, palmatylpalmitate), and Coccus sp. derived waxes (for example, lac, cochineal and Chinese insect); and other animal fats (for example, triglycerides) and waxes including spermaceti (for example, cetylpalmitate), lanolin and wool grease. Also included are derivatives, extracts, and combinations of these materials.

The term "polymer" according to the present invention means e.g. a homopolymer and (co)polymer having from 2 to 50,000 repeating units, which may include block, random, alternate or gradient (co)polymers or combinations thereof and have wax-like chemical or physical properties. Polymers may also be combined with other above-mentioned waxes. In the melt, polymer or (co)polymer interfaces can be considered as "fluid" with dynamics much slower than for conventional liquids. Polymers according to the invention are preferably selected from the group consisting of isoprene polymers, hydrogenated rubber, butadiene polymers, chloroprene polymers and butyl polymers.

According to a further preferred embodiment of the invention, the first material is selected from the group consisting of polymers and waxes; wherein the polymer is preferably selected from the group consisting of polybutylvi-nylether, poly-cis-chlorobutadiene, polyethylene adipate, polyethylene oxide, poly-cis-isoprene, poly-trans-isoprene, propylene oxide, polyvinyl acetal or polyvinyl butyral, polyethylene or compositions or mixtures thereof; and/or wherein the wax is preferably selected from the group consisting of natural wax and synthetic wax, preferably paraffins, silicon waxes, polyether waxes and polyester waxes, or compositions or mixtures thereof.

The melting temperature or melting point is an important characteristic of the first material of the present invention in the sense that the first material is capable of reaching a fluid or liquid-like state in which the colloidal particles can at least partially immerse in the first material. The term "melting point", when applied to the first material, suggests not a solid-liquid phase transition but a transition from a solid or semi-solid state to a fluid (liquid-like) state. In a further preferred embodiment, the first material has a melting temperature from 25°C to 150°C, preferably from 30 to 85°C, particularly preferred from 35 to 65°C. Further preferred, the first material is non-reactive with the reagents or solvents to which it is exposed.

The switchable element according to the invention comprises a substrate covered by a first material and colloidal particles, which at least partially immerse into the first material.

The term "immersion" or "immersed colloidal particles" refers to the colloidal particles, which are partially immersed or incorporated / integrated into the first material.

The term "degree of immersion" (H) refers to a height of particles above the surface of a first material. In particular, the degree of immersion may be determined using different analytical techniques such as contact angle measurement, AFM or other kind of specific microscopes known to the skilled person.

According to a preferred embodiment of the invention, the degree of immersion of the colloidal particles in the first material is between 0 and 100 %, preferably between 5 and 95 %.

According to one embodiment of the invention, the surface of the switchable element according to the present invention can be further modified on nanometer, micrometer or higher scale to generate a patterned surface. The term "pattern" refers to a specific structure of a surface, which, according to a preferred embodiment, repeats on this surface in a predictable manner. For example, a template or a special mask can be used to generate said specific structure or a part of said structure. According to one embodiment, the patterns are based on repetition and reproducibility.

According to another embodiment of the invention, the switchable element provides a surface of a pattern of at least one first area, wherein the colloidal particles have a first degree of immersion, and at least one second area, wherein the colloidal particles have a second degree of immersion different from said first degree of immersion.

Such patterns may have any desired form and are advantageous to provide different areas or spots having different surface properties.

According to a preferred embodiment of the invention, the degree of immersion of the colloidal particles in a first area (on the surface) of the switchable element is different from the degree of immersion in a second area of the switchable element.

According to a further preferred embodiment of the invention, the first area and second area are arranged in a pattern at the surface of the switchable element.

The invention is further directed to a method for the preparation of a switchable element according to the invention, comprising the steps of:

(a) providing colloidal particles, a first material and a second material;

(b) providing an emulsion comprising the colloidal particles, the first material and the second material from step (a);

(c) forming first material particles comprising colloidal particles from the emulsion;

(d) applying the first material particles comprising colloidal particles to the surface of a substrate;

(e) melting the first material particles comprising colloidal particles on the surface of the substrate.

In step (a) of the method according to the invention, the colloidal particles, a first material and a second material are provided.

The term "second material" refers to any material which is substantially immiscible with the first material, i.e. forms a separate phase, and does not solidify under the same conditions as the first material.

According to a preferred embodiment of the invention, the second material is selected from the group consisting of water, organic solvents, organic solutions and inorganic solutions. Particularly preferred the second material is water. Preferred inorganic solutions include water-based solutions comprising an inorganic acid or base. Examples of inorganic acids include hydrochloric acid, sulfuric acid, nitric acid, phosphoric acid, hydrobromic acid and boric acid. Examples of inorganic bases include potassium hydroxide, sodium hydroxide, lithium hydroxide and ammonium hydroxide. Preferred organic solutions include water-based solutions comprising an organic acid. Examples of organic acids include formic acid, acetic acid and citric acid. Preferred organic solvents include dicloro-methane, tetrahydrofuran, ethyl acetate, acetone, dimethylformamide, acetonitrile, dimethylsulfoxide and alcohols, e.g. n-butanol, n-propanol, ethanol and methanol, hydrocarbons including alkanes such as dodecane and hexadecane, aromatic hydrocarbons including toluene and benzene, other similar solvents and combinations thereof. The choice of the second material selected is dependent on the nature of the first material and the colloidal particles used to form an emulsion.

In step (b) of the method according to the invention, an emulsion comprising the colloidal particles, the first material and the second material from step (a) is formed / provided.

The term "emulsion" refers to a combination of at least two components, wherein one of the components is present in the form of droplets in the other component. The emulsion can be obtained by mixing or stirring the corresponding components and with or without adding subsequent stabilizing agent. The components may be added to each other simultaneously or consecutively. On the other hand, two components may be at first mixed together and then added to the third component.

In step (c) of the method according to the invention, the first material particles comprising colloidal particles are formed from the emulsion. In other words, particles are formed comprising the first material and the colloidal particles.

The emulsion is formed by adding or otherwise suspending colloidal particles and the first material in the second material, or otherwise combining those components. The first material is in the form of small drops or droplets and is substantially immiscible in the second material. The emulsion is made at a temperature where the first material is in a molten (liquid or fluid) state. In the process of coating the surface of the droplets comprising the first material with the colloidal particles, the colloidal particles self-assemble at the interface between the two materials. The self-assembling is generally driven by the minimization of total interfacial energies, in particular first material/second material, first material/ colloidal particles, second material/colloidal particles. According to a preferred embodiment of the invention, at least about 90%, preferably at least about 95%, particularly preferred at least about 99% of the surface area of the droplets comprising the first material is covered with colloidal particles.

The first material particles comprising colloidal particles (colloidosomes) may then be stabilized in a variety of ways. For example, the particles may be linked to each other by van der Waals forces or other electrostatic interactions, with use e.g. of chemical cross-linking agents for interfacial cross-linking. The latter processes can lead to physical linking or attachment of the particles to each other. According to a further preferred embodiment of the invention, the colloidal particles are linked by cross-linking between reactive surfaces of neighboring particles. In another preferred embodiment of the invention, the emulsion comprising the first material particles comprising colloidal particles is stabilized by adding a surfactant or a polyelectrolyte.

After that the emulsion is cooled down to a temperature sufficiently low to fix the colloidal particles at the first material / second material interface and thus to form the first material particles comprising colloidal particles, preferably below the solidification point of the first material, e.g. down to a temperature of 25°C or below.

In step (d) of the method according to the invention, the first material particles comprising colloidal particles are brought into contact with the surface of a substrate.

According to the invention, several techniques, in particular horizontal- and vertical-deposition techniques, can be used for the preparation of a layer of the first material particles comprising colloidal particles on the surface of a substrate.

In the horizontal-deposition technique, an emulsion comprising the first material particles comprising colloidal particles and the second material are deposited on the surface of a substrate. Afterwards, the second material is (partially) evaporated. In this way, a well-ordered layer comprising the first material particles comprising colloidal particles on the surface of a substrate was obtained.

In the vertical-deposition technique, e.g. the homogeneous formation of a layer, in particular a monolayer, can be successfully achieved by immersing and carefully withdrawing from the corresponding emulsion a substrate, thus forming a layer of first material particles comprising colloidal particles on the substrate. According to this technique, the substrate to be coated is immersed in an emulsion and withdrawn vertically at a well defined speed. In this case, the withdrawal rate of a substrate equals to the layer formation rate. This technique allows preparing homogeneous, well-ordered layer comprising the first material particles comprising colloidal particles.

In step (e) of the method according to the invention, the first material particles comprising colloidal particles are melted on the surface of the substrate in order to obtain a switchable element.

The melting of the first material particles comprising colloidal particles on a substrate surface can be done under different conditions depending on the properties of a switchable element to be achieved:

(a) Melting the first material particles comprising colloidal particles in a dry ambient medium, e.g. in air, leads to formation of a switchable element, wherein the particles are deeply immersed in the first material, thereby providing a hydrophobic surface.

(b) Melting the first material particles comprising colloidal particles in a liquid ambient medium, e.g. in water, leads to formation of a switchable element, wherein the particles are only slightly immersed in the first material, thereby providing a hydrophilic surface.

Interfacial particle-containing elements in particular at nanometer and micrometer scales can be used to generate micropatterned solid surfaces, which have potential applications in microelectronic, optic and biological microanalysis. A further object of the invention therefore is directed to a method for preparing a switchable element according to the present invention, having on a surface at least one first area, wherein the colloidal particles have a first degree of immersion, and at least one second area, wherein the colloidal particles have a second degree of immersion different from said first degree of immersion, the method comprising:

(a) providing a switchable element according to the invention;

(b) treating the first area(s) but not the second area(s), or the second area(s) but not the first area(s) with at least one external stimulus in order to change the degree of immersion of the colloidal particles on the treated area(s) and to produce the pattern on the surface of the switchable element.

The first and second areas, respectively, or a pattern of such areas according to the present invention, are formed on the surface of the already formed switchable element by treating the first or the second area(s) with at least one external stimulus in order to change the degree of immersion of the colloidal particles. Controlled manufacturing of the areas and patterns, respectively, can be achieved by treating with at least one external stimulus under controlled conditions. In this way, several types of areas or patterns from various colloidal particles can be reproducibly prepared using local treatment with a stimulus such as temperature (e.g. hot needle or laser beam), radiation (e.g. UV- or IR-radiation), humidity (e.g. water steam), solvent or combination thereof.

The method according to the invention might be used, for example, to form areas or precise patterns containing areas that have hydrophobic properties and other that have hydrophilic properties. Depending on the design of such patterns, specific cells or molecules will stick to the switchable element. Such a technology can e.g. be used in the laboratory for speedy chemical or genetic screening of blood and other biological materials.

The switchable element according to the invention may be used to detect a stimulus, such as temperature, radiation or humidity. A further object of the invention is directed to a method of physical switching the switchable element according to the present invention, comprising the steps of:

(a) providing the switchable element;

(b) applying at least one external stimulus to the switchable element;

wherein the switchable element responds to the at least one external stimulus by changing the degree of immersion of the colloidal particles in the first material.

According to one embodiment, it has surprisingly been found that modified and unmodified colloidal particles deeply immerse in the first material after treatment with an external stimulus, in particular when applying a temperature above the melting point of the first material, in dry environment (e.g. absence of water in the ambient medium). Further, the colloidal particles e.g. immerse only slightly in the first material when applying temperature and in the presence of water in the ambient medium. Thus, the surface properties of the switchable element can be switched, in particular reversibly switched, between hydrophobic and hydrophilic states by applying at least one external stimulus. As discussed above, according to a first aspect of the invention, a switchable element is provided. The suitable embodiment of the switchable element is selected according to the analytical problem to be solved, in particular the stimulus to be applied to the switchable element. According to a preferred embodiment of the invention, the external stimulus is selected from the group consisting of temperature, radiation, preferably UV- of IR-radiation, humidity and presence or absence of water in the ambient medium surrounding the switchable element. For detecting e.g. the presence or absence of water or determining humidity, it is e.g. possible to select a switchable element comprising non-patterned or patterned surface. The colloidal particles comprised in the switchable element may be selected e.g. according to the physical parameter of the switchable element used to detect the presence or absence of a stimulus.

To obtain a reference value, the corresponding physical parameter of the switchable element, such as degree of immersion of the colloidal particles in the first material, is detected in the absence of the stimulus. A reference value may be obtained from a switchable element in a dry state or from a switchable element in a defined state. The determination of a reference value may be interpreted as calibration of the switchable element.

The switchable element is then contacted with at least one external stimulus to be determined. After obtaining equilibrium between the switchable element and applied stimulus, the degree of immersion of the colloidal particles in the first material is determined again thereby obtaining a measured value. The presence, absence or intensity of the stimulus may then be determined by comparing the reference value and the measured value.

It has been unexpectedly found that the properties of the switchable element obtained by using the method(s) according to the invention have improved properties with respect to wide ranging applications in the field physic, chemistry, semiconductor technology, biology, biotechnology and medicine.

The present invention is therefore also directed to the method of using of a switchable element according to the invention in optoelectronic, sensor or biotechnological applications.

Preferably, the present invention is directed to the method of using of a switchable element according to the invention for the design of microfluidic devices, functional coatings, logical devices or a pattern. In particular, the present invention is directed to the method of using of a switchable element for design of switchable surfaces for offset printing of pigments, proteins as well as cells.

Microfluidics is a new technology platform that deals with the behavior, precise control and manipulation of fluids that are geometrically constrained to a small, typically sub-millimeter, scale. In particular, the term "microfluidic device" refers to a device comprising one or more channels with at least one dimension less than 1 mm. Microfluidic systems analyze by controlling the flow of liquids or gases through a series of tiny channels and valves, thereby sorting them, much as a computer circuit sorts data through wires and logic gates. This allows them to handle biological materials such as DNA, proteins or cells in minute quantities - usually nano-liters or pico-liters (1000 times smaller than a nano-liter). Microfluidic devices can be used to obtain a variety of interesting measurements including molecular diffusion coefficients, fluid viscosity and chemical binding coefficients. Other applications for microfluidic devices include capillary electrophoresis, isoelectric focusing, immunoassays, flow cytometry, sample injection of proteins for analysis via mass spectrometry, cell manipulation, cell separation and cell patterning.

Functional surface coating is now widely recognized as an enabling technology of major importance in the successful, effective, and efficient exploitation of materials in e.g. engineering practice. The term "functional coating" refers to a system which possesses, besides the classical properties of a coating, an additional functionality. This additional functionality may be diverse, and depend upon the actual application of a coated substrate. Creation and synthesis of advanced and novel materials, functional coating may be broadly regarded as embracing activities such as surface properties optimization, as an integral part of the design process and synthesis and fabrication technologies.

The term "logical device" refers to an electronic component used in electronic industry.

The invention will now be described in more detail by way of non-limiting examples and with reference to the accompanying figures:

Fig. 1. schematically shows switching of the first material / colloidal particles surface.

Fig. 2. shows switching of the switchable element comprising unmodified silica particles as colloidal particles, wax as a first material and silicon wafer as a substrate; AFM (second from left) and SEM (third from left) images of silica particles on wax surface.

Fig. 3. shows simulated (a) and experimentally obtained (b-d) wetting properties of the switchable element, in particular particle/wax surfaces, after annealing in dry and aqueous environment:

(a) simulated water contact angle on unmodified (dotted and dash-dotted lines ) and APS-coated (dashed and solid lines) wax-particle surfaces after annealing in air (solid lines) and under water (dashed lines) at different surface coverage of wax surface by the particles; water contact angles after annealing in air and in water of (b) wax-silica particle surface; (c) wax-APS-modified silica particle surface; (d) reference wax surface.

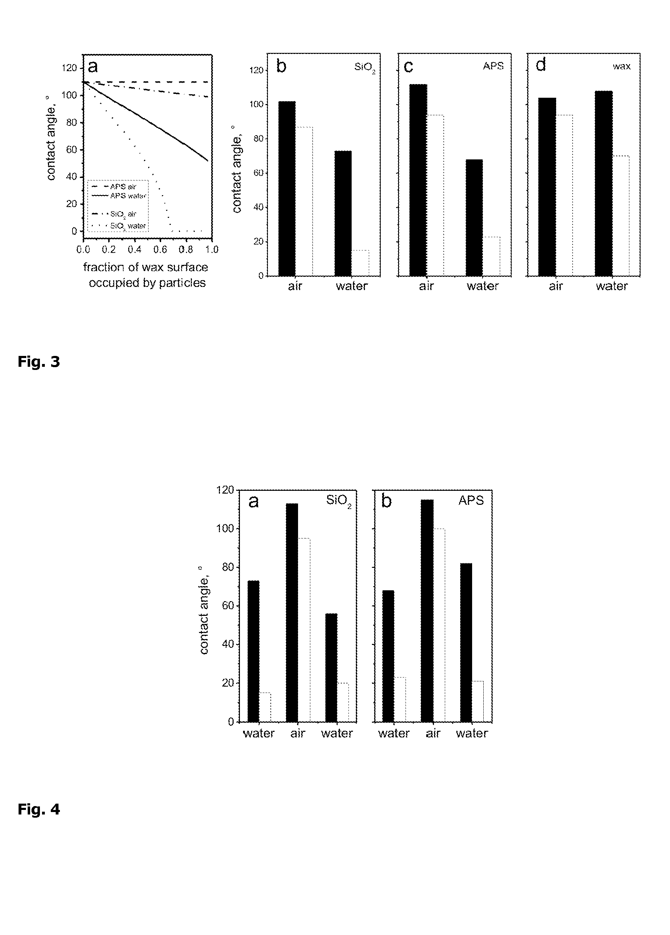

Fig. 4. shows switching of water contact angles on wax-silica particles (a) and wax-APS particles (b) surfaces after sequential annealing in water, in air and in water again.

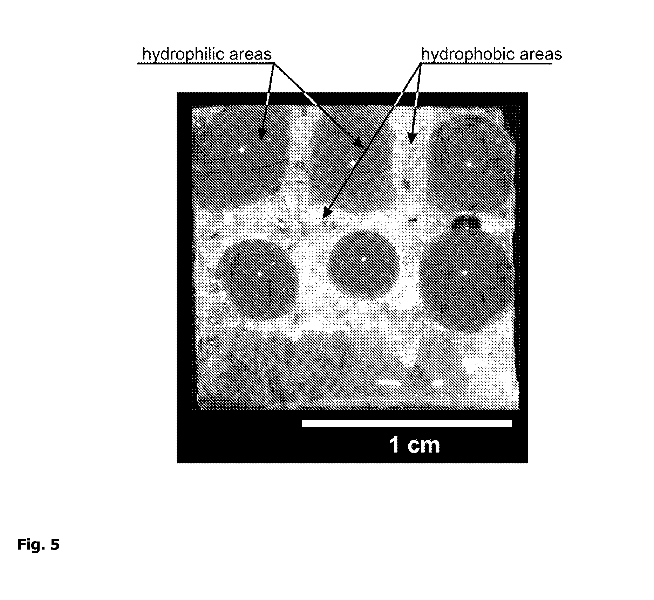

Fig. 5. shows APS-particle/wax patterned surface.

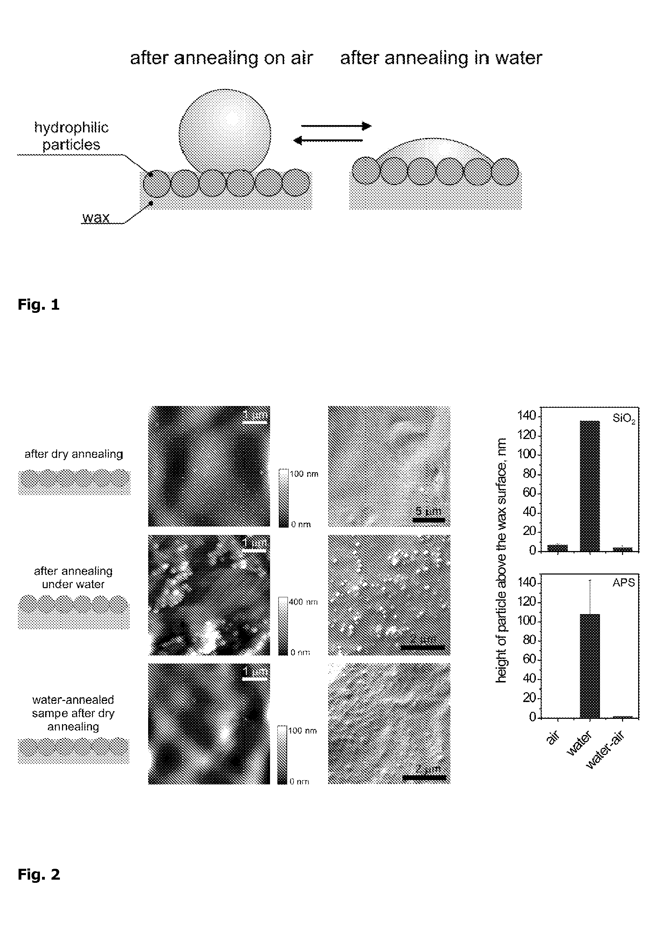

Fig. 1. schematically shows switching of the first material / particle surface of the switchable element, in particular wax-particle surface, wherein the hydrophilic particles were mixed with hydrophobic wax (the first material). Annealing in water and in air changes the degree of immersion (depth of immersion) of the particles in wax layer that switches properties of the layer between hydrophilic and hydrophobic states.

Fig. 2. shows switching of the switchable element comprising unmodified silica particles as colloidal particles, wax as a first material and silicon wafer as a substrate. Three panels show changing the degree of immersion of unmodified silica particles in wax: after annealing on air (upper panel), annealing in water (middle panel) and annealing on air of the sample preliminary annealed in water (lower panel). Corresponding AFM (second from left) and SEM (third from left) images show the surface of the switchable element.

Immersion state of the silica particles (height of the particles above wax surface, nm) after annealing on air, under water and after second annealing on air of unmodified and APS-modified silica particles was derived from AFM images (right plot).

Fig. 3. shows differences in hydrophobisity / hydrophilicity of modified and unmodified with APS silica particles upon treating said particles with one external stimulus such as temperature and with two external stimulus such as temperature and water (ambient medium).

Fig. 4. shows reversible switching of the switchable elements comprising wax-silica particle (a) and wax-APS particle (b) on silicon wafer as a substrate.

Fig. 5. shows hydrophilic/hydrophobic patterning of APS-particle/wax surface using heated needle. APS-particle/wax surface was switched to hydrophilic state by annealing in aqueous environment. Applying heated needle locally switches the surface into hydrophobic state. Water (colored with rhodamine) selectively wets the hydrophilic areas and is unable to wet the areas where the need was applied.

**Examples**

Example 1: Preparation of modified silica particles:

200 nm silica particles were washed three times in dichloromethane followed by drying in vacuum oven at 110°C. 3-aminopropyltriethoxysilane (APS) was chemisorbed from a 2wt.-% ethanol solution for 24 hours. To remove nonadsorbed APS, the particles were rinsed and centrifuged five times in ethanol.

Example 2: Fabrication of the switchable element:

0.2 g of unmodified (native) or 3-aminopropyltriethoxysilane (APS)-modified 200 nm silica particles was dispersed homogeneously in 1 g of paraffin wax at 75°C and then mixed with 10 g of Millipore water. The emulsions were produced using magnetic stirring at 1600 rpm for 1 hour and then were cooled to room temperature (25°C), at which paraffin wax is solid. Deionized water was used to wash the wax emulsions multiple times to remove particles in the aqueous solution as well as weakly attached particles.

The resulting emulsion was melted on water surface at T=60°C and cooled down to T=20°C. The formed film was then brought in contact with a silicon wafer.

Then, the coated substrate was heated up to a temperature of 60°C to melt the paraffin wax and to allow the silica particles to migrate through the paraffin wax to the surface of the switchable element.

Example 3: Effect of gravity on the degree of immersion of the colloidal particles

Silicon wafers coated with the layer comprising paraffin wax / silica particles (both modified and unmodified silica particles) were prepared according to Example 2. One part of said coated silica wafers was positioned horizontally and another part was positioned vertically. Both parts were heated up to a melting point of the paraffin wax (57-59°C). Degree of immersion of the silica particles in the paraffin wax has been studied using Atomic Force Microscopy (AFM).

It was observed that the particles were virtually completely immersed in wax in both cases resulting in no influence of gravity on the degree of immersion of the particles. In agreement with experimental results, theoretical calculation predicts that interfacial forces acting on 200 nm large particles are ca. $10^{-10}$ N that dramatically exceeds the gravity force, which is estimated to be ca. $10^{-19}$ N.

Example 4: Switching of the switchable element

A switchable element was prepared according to Example 2. Treating with a temperature of 57-59°C was done in aqueous (under water) and dry (in air) environments. It has been found (see Fig. 2) that both unmodified and APS-modified silica particles were almost completely immersed into wax at the wax-air interface. On the other hand, particles were found to be only slightly immersed in wax at the water-wax interface. The degree of immersion (H) of unmodified and APS-modified particles is different - H = 35% and H = 45%, respectively, which is in good qualitative correlation with our estimation based on contact angle data (Table 1 and 2) using formula

$$H = 100\% \cdot (\cos \Theta + 1)/2$$

(Synytska, A.; Ionov, L.; Dutschk, V.; Stamm, M.; Grundke, K. Langmuir 2008, 24, 11895).

Table 1. Experimentally measured values of contact angles at different interfaces.

| interface | water contact angle, ° | interface | hexadecane contact angle, ° |
|---|---|---|---|
| APS-water-air | 70 | $SiO_2$-hexadecane-air | 0 |
| $SiO_2$-water-air | 43 | $SiO_2$-hexadecane-water | 154 |
| Wax-water-air | 107 | APS-hexadecane-air | 0 |
| | | APS-hexadecane-water | 122 |

Hexadecane contact angles in aqueous environment were calculated as difference of 180° and water contact angle on wafer immersed in hexadecane.

Table 2. Experimentally obtained and estimated degree of immersion of unmodified and APS-modified silica particles in wax depending on the environment.

| particles | annealing conditions | degree of particle immersion in wax, % | |
|---|---|---|---|
| | | experimental | estimated using contact angles from Table 1 |
| unmodified | air | 95 | 100 |
| | water | 35 | 5 |
| APS-modified | air | 100 | 100 |
| | water | 45 | 23 |

Example 5: Wetting properties of composite wax-particle surfaces

The switchable element was prepared according to Example 2. Wetting properties said switchable element comprising composite wax-particle surface have been investigated in theoretical and experimental way as shown below.

The wetting properties of wax-particle surface are determined by several parameters: hydrophobicity and surface roughness provided by the particles as well as hydrophobicity of the wax. Although there are many models, which may be used to simulate wetting behavior of wax surfaces with particles, we applied the Cassie-Baxter equation (1).

For simplicity, only the case is considered when the water droplets collapsed on the surface. In this case, liquid completely fills the grooves between particles (collapsed drop) that leads to low receding angle. The following modification of the Cassie-Baxter equation was used:

$$\cos\Theta = f_{particle}^{wax} \cdot r_{particle}^{wax} \cdot \cos\Theta_{particle}^{water} + \left(1 - f_{particle}^{water}\right) \cdot \cos\Theta_{wax}^{water} \qquad (1)$$

, where $\cos\Theta_{particle}^{water}$ and $\cos\Theta_{wax}^{water}$ are the intrinsic water contact angles on the particle and wax surfaces, respectively; $f_{particle}^{wax} = n\pi R_p^2 \left(2h^* - h^{*2}\right)$ is the area fraction of particles on the surface of wax; $r_{particle}^{wax} = \dfrac{2}{2 - h^*}$ is roughness factor of particle cap above wax surface; $f_{particle}^{water} = n\pi R_p^2 \left(1 - \cos\Theta_{particle}^{water}{}^2\right)$ fraction of water surface in contact with the particle caps; $h^* = 1 - \cos\Theta_{wax}^{air\_or\_water}$ is normalized height of particle cap immersed in wax; $n = \dfrac{N}{S}$ is the number of particles (N) per areas (S); $n_{\max} = \dfrac{1}{2\sqrt{3}R_p^2}$ is maximum number density of particles on surface, which corresponds to closely packed particles.

Performed simulations demonstrate that the unmodified (native) and APS-modified particle-wax surfaces provide different wetting properties after annealing on air and in water, i.e. the particle-wax surface is hydrophilic after annealing in water and is hydrophobic after annealing in air. The contrast between hydrophilic and hydrophobic states increases with the density of particles on the surface (Fig. 3a).

Experimental investigation of the wetting properties on obtained wax-particle layers after annealing in different media was performed using water contact angle measurements. It was found that the wax-particle surface is more hydrophilic after annealing in water then after annealing on air (Fig. 3b, c). Due to small contact angle hysteresis the water droplets are relatively flexible on the wax-particle surface annealed on air and can be removed by slight shaking. On the other hand, the water droplets remain strongly pinned to wax-particles surface annealed in water. We performed a control experiment and investigated wetting properties of wax (without particles) annealed on air and in water. The wax surface becomes slightly more hydrophilic after annealing in aqueous environment which is seen from the expresses in decrease of the receding contact angle (Fig.3d). The advancing water contact angles on the wax surfaces annealed in dry and aqueous environments are nearly the same. Therefore, it can be concluded that the difference in wetting properties of wax-particle surface annealed at different conditions originates from the different degrees of immersion of particles into wax surface.

Example 6: Reversible switching of the switchable element

The switchable element was prepared according to Example 2. The reversible switching of the switchable element is shown in Fig. 4. The hydrophilic wax-particle film, which was preliminary annealed in water, was used for the switching experiments. This film was melted in a dry state. It was found that the particle-wax films switch into hydrophobic state after annealing in air. The second annealing in water switches the layer back into the hydrophilic state. Thus, the wax-particle layer demonstrates fully reversible switching of wetting properties after annealing in dry and aqueous environment.

Example 7: APS-particle/wax patterned surface

The switchable element, which was preliminary switched to hydrophilic state by annealing in water (prepared according to Example 2) was used to study the applicability of the developed stimuli-responsive surfaces for hydrophilic-hydrophobic patterning. As an external stimulus a hot needle was locally applied to the surface of the switchable element. **[0093]** As expected (Fig. 5), a locally applied hot needle switches the particle-wax surface to hydrophobic state. In fact, it has been found that water readily wets areas where no needle was applied (hydrophilic areas) while water does not wet the areas where the needle was applied (hydrophobic area). In this way it was possible to produce a patterned structure on the surface of the switchable element.
According to one aspect, the invention also relates to the following numbered items:

1. A switchable element comprising a substrate, a first material and colloidal particles, wherein the first material in a fluid state allows the colloidal particles to at least partially immerse into the first material, and wherein the colloidal particles are responsive to an external stimulus that changes their degree of immersion in the first material, and wherein at a temperature below the melting point of the first material the colloidal particles are fixed in their degree of immersion.

2. The switchable element according to item 1, wherein the melting temperature of the first material is from 25 to 150°C, preferably from 30 to 85°C.

3. The switchable element according to item 1 or 2, wherein the degree of immersion of the colloidal particles in the first material is between 0 and 100 %, in particular between 5 and 100 %.

4. The switchable element according to any of items 1 to 3, wherein the degree of immersion of the colloidal particles in a first area at the surface of the switchable element is different from the degree of immersion in a second area at the surface of the switchable element.

5. The switchable element according to item 4, wherein first area and second area are arranged in a pattern at the surface of the switchable element.

6. The switchable element according to any of items 1 to 5, wherein the colloidal particles are inorganic or organic particles,
wherein the inorganic particles are preferably selected from the group consisting of metals, metal oxides, metal hydroxides, semiconductor materials, non-conductive materials and silica, preferably FeO, $Fe_2O_3$ and $SiO_2$, or compositions or mixtures thereof; and
wherein the organic particles are preferably polymer or (co)polymer particles, which are preferably selected from the group of thermoplastic materials comprising polystyrene, polyolefins, in particular polyethylene or polypropylene; polyacrylates, polymethacrylates; polyimides, polycarbonates, polyethersulfones, polyamides, polyesters; and polyvinyl chlorides; styrene-butadiene rubber (SBR); styrene-ethylene-butadiene-styrene copolymers (SEBS); butyl rubber; ethylene-propylene rubber (EPR); ethylene-propylene-diene-monomer rubber (EPDM); ethylene-vinyl acetate copolymer (EVA); ethylene-acrylate or butadiene-acrylonitrile; maleic anhydride modified polymers and copolymers; and graft copolymers; or compositions or mixtures thereof.

7. The switchable element according to any of items 1 to 6, wherein the colloidal particles are unmodified or modified particles.

8. The switchable element according to item 7, wherein the modified particles are functionalized by at least one organic molecule, preferably by a silane derivative, preferably by 3-aminopropyltriethoxysilane.

9. The switchable element according to any of items 1 to 8, wherein the colloidal particles have a diameter between 1 nm and 100 $\mu$m, preferably between 20 nm and 500 nm.

10. The switchable element according to any of items 1 to 9, wherein the first material is selected from the group consisting of polymers and waxes;
wherein the polymer is preferably selected from the group consisting of polybutylvinylether, poly-cis-chlorobutadiene, polyethylene adipate, polyethylene oxide, poly-cis-isoprene, poly-trans-isoprene, propylene oxide, polyvinyl acetal or polyvinyl butyral, polyethylene or compositions or mixtures thereof; and wherein the wax is preferably selected from the group consisting of natural wax and synthetic wax, preferably paraffins, silicon waxes, polyether waxes and polyester waxes, or compositions or mixtures thereof.

11. A method for the preparation of a switchable element as defined in any of items 1 to 10, comprising the steps of:

(a) providing colloidal particles, a first material and a second material;

(b) forming an emulsion comprising the colloidal particles, the first material and the second material from step (a) with particles comprising the first material and colloidal particles (first material particles comprising colloidal particles);

(c) applying the first material particles comprising colloidal particles to the surface of a substrate;

(d) melting the first material particles comprising colloidal particles on the surface of the substrate.

12. The method according to item 11, wherein the second material is selected from the group consisting of water, organic solvents, organic solutions and inorganic solutions, preferably of water.

13. A method for preparing a switchable element as defined in any of items 1 to 10 or prepared according to any of items 11 and 12, having on a surface a pattern of at least one first area, wherein the colloidal particles have a first degree of immersion, and at least one second area, wherein the colloidal particles have a second degree of immersion different from said first degree of immersion, the method comprising:

(a) providing a switchable element as defined in any of items 1 to 10 or prepared according to any of items 11 and 12;

(b) treating the first area(s) but not the second area(s), or the second area(s) but not the first area(s) with at least one external stimulus in order to change the degree of immersion of the colloidal particles on the treated area(s) and to produce the pattern on the surface of the switchable element.

14. A method of physical switching the switchable element as defined in any of items 1 to 10 or prepared according to any of items 11 and 12 or 13, comprising the steps of:

(a) providing the switchable element;

(b) applying at least one external stimulus to the switchable element;

wherein the switchable element responds to the at least one external stimulus by changing the degree of immersion of the colloidal particles in the first material.

15. The method according to item 13 or 14, wherein the external stimulus is selected from the group consisting of temperature, radiation, preferably UV- of IR-radiation, humidity and presence or absence of water in the ambient medium surrounding the switchable element.

16. Use of a switchable element according to any of items 1 to 10 or prepared according to any of items 11 and 12 or 13 in optoelectronic, sensor or biotechnological applications.

17. Use of a switchable element according to item 16 for the design of microfluidic devices, functional coatings, logical devices or a pattern.

**Claims**

1. A switchable element comprising a substrate, a first material and colloidal particles, wherein the first material in a fluid state allows the colloidal particles to at least partially immerse into the first material, and wherein the colloidal particles are responsive to an external stimulus that changes their degree of immersion in the first material, and wherein at a temperature below the melting point of the first material the colloidal particles are fixed in their degree of immersion.

2. The switchable element according to claim 1, wherein the melting temperature of the first material is from 25 to 150°C, preferably from 30 to 85°C.

3. The switchable element according to any of claims 1 to 2, wherein the degree of immersion of the colloidal particles in a first area on the surface of the switchable element is different from the degree of immersion in a second area on the surface of the switchable element.

4. The switchable element according to claim 3, wherein first area and second areas are arranged in a pattern at the surface of the switchable element.

5. The switchable element according to any of claims 1 to 4, wherein the colloidal particles are inorganic or organic particles,
   wherein the inorganic particles are preferably selected from the group consisting of metals, metal oxides, metal hydroxides, semiconductor materials, non-conductive materials and silica, preferably FeO, $Fe_2O_3$ and $SiO_2$, or compositions or mixtures thereof; and
   wherein the organic particles are preferably polymer or (co)polymer particles, which are preferably selected from the group of thermoplastic materials comprising polystyrene, polyolefins, in particular polyethylene or polypropylene; polyacrylates, polymethacrylates; polyimides, polycarbonates, polyethersulfones, polyamides, polyesters; and polyvinyl chlorides; styrene-butadiene rubber (SBR); styrene-ethylene-butadiene-styrene copolymers (SEBS); butyl rubber; ethylene-propylene rubber (EPR); ethylene-propylene-diene-monomer rubber (EPDM); ethylene-vinyl acetate copolymer (EVA); ethylene-acrylate or butadiene-acrylonitrile; maleic anhydride modified polymers and copolymers; and graft copolymers; or compositions or mixtures thereof.

6. The switchable element according to any of claims 1 to 5, wherein the colloidal particles are modified particles, and wherein preferably the modified particles are functionalized by at least one organic molecule, preferably by a silane derivative, preferably by 3-aminopropyltriethoxysilane.

7. The switchable element according to any of claims 1 to 6, wherein the colloidal particles have a diameter between 1 nm and 100 $\mu$m, preferably between 20 nm and 500 nm.

8. The switchable element according to any of claims 1 to 7, wherein the first material is selected from the group consisting of polymers and waxes;
   wherein the polymer is preferably selected from the group consisting of polybutylvinylether, poly-cis-chlorobutadiene, polyethylene adipate, polyethylene oxide, poly-cis-isoprene, poly-trans-isoprene, propylene oxide, polyvinyl acetal or polyvinyl butyral, polyethylene or compositions or mixtures thereof; and
   wherein the wax is preferably selected from the group consisting of natural wax and synthetic wax, preferably paraffins, silicon waxes, polyether waxes and polyester waxes, or compositions or mixtures thereof.

9. A method for the preparation of a switchable element as defined in any of claims 1 to 8, comprising the steps of:

   (a) providing colloidal particles, a first material and a second material;
   (b) forming an emulsion comprising the colloidal particles, the first material and the second material from step (a);
   (c) forming first material particles comprising colloidal particles from the emulsion;
   (d) applying the first material particles comprising colloidal particles to the surface of a substrate;
   (e) melting the first material particles comprising colloidal particles on the surface of the substrate.

10. The method according to claim 9, wherein the second material is selected from the group consisting of water, organic solvents, organic solutions and inorganic solutions, preferably of water.

11. A method for preparing a switchable element as defined in any of claims 1 to 8 or prepared according to any of claims 9 and 10, having on a surface a pattern of at least one first area, wherein the colloidal particles have a first degree of immersion, and at least one second area, wherein the colloidal particles have a second degree of immersion different from said first degree of immersion, the method comprising:

   (a) providing a switchable element as defined in any of claims 1 to 8 or prepared according to any of claims 9 and 10;
   (b) treating the first area(s) but not the second area(s), or the second area(s) but not the first area(s) with at least one external stimulus in order to change the degree of immersion of the colloidal particles on the treated area(s) and to produce the pattern on the surface of the switchable element.

12. A method of physical switching the switchable element as defined in any of claims 1 to 8 or prepared according to any of claims 9 to 11, comprising the steps of:

   (a) providing the switchable element;
   (b) applying at least one external stimulus to the switchable element; wherein the switchable element responds to the at least one external stimulus by changing the degree of immersion of the colloidal particles in the first material.

13. The method according to claim 11 or 12, wherein the external stimulus is selected from the group consisting of temperature, radiation, preferably UV- of IR-radiation, humidity and presence or absence of water in the ambient medium surrounding the switchable element.

14. Use of a switchable element according to any of claims 1 to 8 or prepared according to any of claims 9 to 11 in optoelectronic, sensor or biotechnological applications.

15. Use of a switchable element according to claim 14 for the design of microfluidic devices, functional coatings, logical devices or a pattern.

after annealing on air    after annealing in water

hydrophilic
particles

wax

**Fig. 1**

after dry annealing

after annealing
under water

water-annealed
sampe after dry
annealing

**Fig. 2**

**Fig. 3**

**Fig. 4**

Fig. 5

Europäisches
Patentamt

European
Patent Office

Office européen
des brevets

# EUROPEAN SEARCH REPORT

**Application Number**

EP 10 16 9077

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | BERGER S. ET AL: "Stimuli-Responsive biocomponent polymer janus particles by "Grafting from"/"Grafting to" approaches", MACROMOLECULES, vol. 41, 21 November 2008 (2008-11-21), pages 9669-9676, XP002615985, | 1,2,5-8, 14,15 | INV.<br>B81B1/00<br>B81C1/00<br>B81B3/00 |
| A | * the whole document * | 3,4,9-13 | |
| X | CHUNDER A ET AL: "Conformal switchable superhydrophobic/hydrophilic surfaces for microscale flow control", COLLOIDS AND SURFACES. A, PHYSICACHEMICAL AND ENGINEERING ASPECTS, ELSEVIER, AMSTERDAM, NL, vol. 333, no. 1-3, 5 February 2009 (2009-02-05), pages 187-193, XP025760623, ISSN: 0927-7757, DOI: DOI:10.1016/J.COLSURFA.2008.09.044 [retrieved on 2008-09-30] | 1-8,14, 15 | |
| A | * abstract * <br> * page 188, right-hand column, paragraph 2-4 * <br> * page 189, left-hand column, paragraph 1-3 * <br> * page 191, left-hand column, paragraph 1 * <br> * page 192, left-hand column, paragraph 1 * <br> * figure 1 * | 9-13 | **TECHNICAL FIELDS SEARCHED (IPC)**<br><br>B81B<br>B81C |

-/--

The present search report has been drawn up for all claims

| Place of search | Date of completion of the search | Examiner |
|---|---|---|
| Berlin | 11 January 2011 | Ekoué, Adamah |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

                                     

& : member of the same patent family, corresponding
document

EPO FORM 1503 03.82 (P04C01)

Europäisches
Patentamt
European
Patent Office
Office européen
des brevets

**EUROPEAN SEARCH REPORT**

Application Number

EP 10 16 9077

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2005/178286 A1 (BOHN CLAYTON C JR [US] ET AL BOHN JR CLAYTON C [US] ET AL) 18 August 2005 (2005-08-18) | 1-8,14, 15 | |
| A | * abstract * <br> * page 2, paragraph 29-32 * <br> * page 3, paragraph 36-42 * <br> * page 4, paragraphs 44,53 * <br> * page 5, paragraph 62 * <br> * figures 1(a),1(b),2(a),2(b) * <br> ----- | 9-13 | |
| X | EP 1 857 865 A2 (XEROX CORP [US]) 21 November 2007 (2007-11-21) | 1-5,7,8 | |
| A | * abstract * <br> * page 9, paragraphs 52,57,61 * <br> * page 13, paragraphs 96,102,103 * <br> * page 14, paragraph 106 * <br> * page 29, paragraph 214-217 * <br> * figure 16 * <br> ----- | 6,9-15 | |
| A | RAMANAVICIENE A ET AL: "AFM study of conducting polymer polypyrrole nanoparticles formed by redox enzyme - glucose oxidase - initiated polymerisation", COLLOIDS AND SURFACES. B, BIOINTERFACES, ELSEVIER, AMSTERDAM, NL, vol. 48, no. 2, 15 March 2006 (2006-03-15) , pages 159-166, XP025136937, ISSN: 0927-7765, DOI: DOI:10.1016/J.COLSURFB.2006.02.002 [retrieved on 2006-03-15] * abstract * * page 160, right-hand column, paragraph 1 * * page 162, left-hand column, paragraph 2 - page 162, right-hand column, paragraph 2 * * figure 4 * ----- | 1-15 | TECHNICAL FIELDS SEARCHED (IPC) |

-/--

The present search report has been drawn up for all claims

| Place of search | Date of completion of the search | Examiner |
|---|---|---|
| Berlin | 11 January 2011 | Ekoué, Adamah |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches
Patentamt

European
Patent Office

Office européen
des brevets

## EUROPEAN SEARCH REPORT

Application Number

EP 10 16 9077

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | EP 1 760 527 A1 (DWI AN DER RWTH AACHEN E V [DE]) 7 March 2007 (2007-03-07) <br> * column 5, paragraphs 22,23 * <br> * column 6, paragraph 25-27 * <br> * column 7, paragraph 28-34 * <br> * column 8, paragraphs 36,37 * <br> * column 9, paragraph 38 * <br> ----- | 1-15 | |
| A | TOKAREVA I. ET AL: "Nanosensors based on responsive polymer brushes and gold nanoparticle enhanced transmission surface plasmon resonance spectroscopy", JOURNAL OF THE AMERICAN SOCIETY, vol. 126, no. 49, 2004, pages 15950-15951, XP002615986, <br> * the whole document * <br> ----- | 1-15 | |

TECHNICAL FIELDS
SEARCHED (IPC)

The present search report has been drawn up for all claims

| Place of search | Date of completion of the search | Examiner |
|---|---|---|
| Berlin | 11 January 2011 | Ekoué, Adamah |

EPO FORM 1503 03.82 (P04C01)

**ANNEX TO THE EUROPEAN SEARCH REPORT
ON EUROPEAN PATENT APPLICATION NO.**                    EP 10 16 9077

This annex lists the patent family members relating to the patent documents cited in the above-mentioned European search report.
The members are as contained in the European Patent Office EDP file on
The European Patent Office is in no way liable for these particulars which are merely given for the purpose of information.

11-01-2011

| Patent document cited in search report | | Publication date | Patent family member(s) | | Publication date |
|---|---|---|---|---|---|
| US 2005178286 | A1 | 18-08-2005 | AU | 2005280637 A1 | 09-03-2006 |
| | | | CA | 2556662 A1 | 09-03-2006 |
| | | | EP | 1716451 A2 | 02-11-2006 |
| | | | JP | 2007529090 T | 18-10-2007 |
| | | | WO | 2006025857 A2 | 09-03-2006 |
| EP 1857865 | A2 | 21-11-2007 | CA | 2588317 A1 | 19-11-2007 |
| | | | CN | 101075059 A | 21-11-2007 |
| | | | JP | 2007310397 A | 29-11-2007 |
| | | | US | 2007268560 A1 | 22-11-2007 |
| EP 1760527 | A1 | 07-03-2007 | US | 2009308842 A1 | 17-12-2009 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 7020335 B2
- US 20070190299 A1
- US 20070190327 A1

### Non-patent literature cited in the description

- **WENZEL, R. N.** *Ind. Eng. Chem. Res.,* 1936, vol. 28, 988
- **MARMUR, A.** *Langmuir,* 2003, vol. 19, 8343
- **MARMUR, A.** *Langmuir,* 2004, vol. 20, 3517
- **MARMUR, A.** *Langmuir,* 2003, vol. 19, 8343
- **CASSIE, A. B. D. ; BAXTER, S.** *Trans. Faraday Soc.,* 1944, vol. 40, 546
- **MINKO, S. ; MULLER, M. ; MOTORNOV, M. ; NITSCHKE, M. ; GRUNDKE, K. ; STAMM, M.** *Journal of the American Chemical Society,* 2003, vol. 125, 3896
- **SIDORENKO, A. ; KRUPENKIN, T. ; TAYLOR, A. ; FRATZL, P. ; AIZENBERG, J.** *Science,* 2007, vol. 315, 487
- **SYNYTSKA, A. ; IONOV, L. ; DUTSCHK, V. ; STAMM, M. ; GRUNDKE, K.** *Langmuir,* 2008, vol. 24, 11895